# EUROPEAN PATENT APPLICATION

(11) **EP 4 797 246 A1**
(43) Date of publication of application: **26.08.2026**
(21) Application number: 24890063.1
(22) Date of filing: 07.06.2024
(51) Int. Cl.: G09F 9/30, H05K 5/02, H05K 5/03

(54) **FLEXIBLE SCREEN AND FOLDABLE ELECTRONIC DEVICE**

(30) Priority: 15.11.2023 CN 202311527832
(71) Applicant: Huawei Technologies Co., Ltd., Shenzhen, Guangdong 518129 (CN)
(72) Inventor: WU, Wenwen, Shenzhen, Guangdong 518129 (CN); ZHONG, Ding, Shenzhen, Guangdong 518129 (CN); SHEN, Hewen, Shenzhen, Guangdong 518129 (CN); YAN, Zhiguo, Shenzhen, Guangdong 518129 (CN)
(74) Representative: Maiwald GmbH
(86) International application number: PCT/CN2024/097958
(87) International publication number: WO 2025/102694

(57) **Abstract**

This application provides a flexible display and a foldable electronic device. The foldable electronic device includes a housing, and a flexible display that includes a cover plate and a display layer that are stacked. The display layer includes a bending area and a non-bending area. The cover plate includes a flexible part and a rigid part. The flexible part corresponds to the bending area, the rigid part corresponds to the non-bending area, and the rigid part is fastened to the housing. The foregoing technical solutions can implement a narrow-bezel visual design and increase a screen-to-body ratio, thereby improving viewing experience of a user.

## Description

This application claims priority to Chinese Patent Application No. 202311527832.4, filed with the China National Intellectual Property Administration on November 15, 2023 and entitled "FLEXIBLE DISPLAY AND FOLDABLE ELECTRONIC DEVICE", which is incorporated herein by reference in its entirety.

### TECHNICAL FIELD

This application relates to the field of electronic device technologies, and more specifically, to a flexible display and a foldable electronic device.

### BACKGROUND

A foldable electronic device is an important product form at present, and has gained increasing popularity among users due to its practicality. Specifically, a foldable electronic device can switch between a folded state and an unfolded state. It provides a larger display area in the unfolded state, while occupying less space in the folded state.

With continuous development of technologies, users have increasingly higher requirements for the screen-to-body ratio of the foldable electronic device in pursuit of a better visual experience. However, most of current foldable electronic devices have large black borders, which compromises the screen-to-body ratio of the display and results in poor user experience.

### SUMMARY

This application provides a flexible display and a foldable electronic device, to implement a narrow-bezel visual design and increase a screen-to-body ratio, thereby improving viewing experience of a user.

According to a first aspect, a foldable electronic device is provided, including a housing and a flexible display. The flexible display includes a cover plate and a display layer that are stacked. The display layer includes a bending area and a non-bending area. The cover plate includes a flexible part and a rigid part. The flexible part corresponds to the bending area, the rigid part corresponds to the non-bending area, and the rigid part is fastened to the housing.

In this application, the cover plate is in a soft-hard combination form, the flexible part may be bent, and the rigid part is configured to be fastened to the housing, and no additional component is needed for fastening. In this way, visual impact of large black borders caused by the additional component can be avoided, to implement a narrow-bezel visual design and increase a screen-to-body ratio, thereby improving viewing experience of a user.

Because the rigid part is connected to the housing, during folding of the flexible display, there is no significant slippage between the cover plate and the housing, and no obvious warping occurs at an edge of the cover plate, thereby reducing dust intrusion and protecting screen edges.

With reference to the first aspect, in some implementations of the first aspect, a minimum bending angle of the rigid part is greater than 90°, and/or a minimum bending angle of the flexible part is less than or equal to 0°.

With reference to the first aspect, in some implementations of the first aspect, a bending radius of the rigid part is greater than a bending radius of the flexible part.

In this way, the rigid part of the cover plate has high rigidity, and is not prone to reverse bending or arching, which facilitates a fastened connection with the housing. The flexible part of the cover plate has high flexibility, and does not affect folding and unfolding of the flexible display.

With reference to the first aspect, in some implementations of the first aspect, the rigid part is bonded and fastened to the housing.

An adhesive is used to bond the cover plate and the housing, which is simple, fast, and efficient.

With reference to the first aspect, in some implementations of the first aspect, the housing includes a middle frame, and the rigid part is fastened to the middle frame; and/or the housing includes a side frame, and the rigid part is fastened to the side frame.

With reference to the first aspect, in some implementations of the first aspect, the foldable electronic device further includes a connection mechanism. The housing includes a first housing and a second housing, the first housing and the second housing are rotatably connected to the connection mechanism separately, a position of the flexible part corresponds to a position of the connection mechanism, and the rigid part is connected to the first housing and the second housing.

That the position of the flexible part corresponds to the position of the connection mechanism does not affect folding and unfolding of the flexible display.

With reference to the first aspect, in some implementations of the first aspect, a back surface of the flexible display is bonded to the housing.

Because the rigid part of the cover plate has good stiffness, a partial tensile force concentration on the screen caused by adhesive dispensing on a back surface of the non-bending area of the flexible display can be reduced, thereby mitigating a light-and-shadow sudden change caused by the partial tensile force concentration on the screen.

With reference to the first aspect, in some implementations of the first aspect, the back surface of the flexible display is not bonded to the housing.

Because the adhesive is removed, a partial tensile force concentration on the screen caused by adhesive dispensing on the back surface of the non-bending area of the flexible display can be avoided, thereby avoiding a light-and-shadow sudden change caused by the partial tensile force concentration on the screen.

With reference to the first aspect, in some implementations of the first aspect, a thickness of the flexible part is less than a thickness of the rigid part.

The flexible part and the rigid part are formed by partially thinning a thickness of the cover plate. The flexible part has a relatively small thickness, and can implement a bending function.

With reference to the first aspect, in some implementations of the first aspect, a material of the cover plate is any one of the following materials: glass and light-transmitting resin.

With reference to the first aspect, in some implementations of the first aspect, in a thickness direction of the flexible display, a groove is formed between the flexible part and the rigid part, a protrusion is disposed on the display layer, and the protrusion is embedded in the groove.

With reference to the first aspect, in some implementations of the first aspect, in the thickness direction of the flexible display, a groove is formed between the flexible part and the rigid part, and the groove is filled with a flexible material.

In this way, smoothness of display effect can be improved.

With reference to the first aspect, in some implementations of the first aspect, the flexible part includes a first material, the rigid part includes a second material, and the first material is different from the second material.

The cover plate may be formed by joining a plurality of materials, which helps ensure both a bendable function of the flexible part and good stiffness of the rigid part.

With reference to the first aspect, in some implementations of the first aspect, the first material is a flexible material; and/or the second material is a rigid material.

In this way, the rigid part of the cover plate has high rigidity, which facilitates the fastened connection with the housing. The flexible part of the cover plate has high flexibility, and does not affect folding and unfolding of the flexible display.

With reference to the first aspect, in some implementations of the first aspect, the first material includes at least one of the following materials: polypropylene, polyethylene, polyimide, polyamide, polyester resin, and thermoplastic polyurethane; and/or the second material includes at least one of the following materials: glass and light-transmitting resin.

With reference to the first aspect, in some implementations of the first aspect, a surface that is of the flexible part and that faces the rigid part in a first direction is connected to a surface that is of the rigid part and that faces the flexible part in the first direction. The first direction is perpendicular to a thickness direction of the flexible display and is perpendicular to a folding axis of the flexible display.

In this way, no additional film layer is needed, which helps reduce a stacking thickness of the flexible display.

With reference to the first aspect, in some implementations of the first aspect, the flexible display further includes a connection layer, and the connection layer and the cover plate are stacked. The flexible part is connected to the connection layer, and the rigid part is connected to the connection layer.

In this way, the rigid part is connected to the flexible part by using the connection layer, so that a contact area can be increased, and connection reliability can be ensured.

With reference to the first aspect, in some implementations of the first aspect, a material of the connection layer is ultra-thin glass or optical resin.

With reference to the first aspect, in some implementations of the first aspect, the connection layer is disposed between the cover plate and the display layer; or the cover plate is disposed between the connection layer and the display layer.

With reference to the first aspect, in some implementations of the first aspect, the cover plate is disposed on a side that is of the display layer and on which a light-emitting surface is located.

According to a second aspect, a flexible display is provided, including a cover plate and a display layer that are stacked. The display layer includes a bending area and a non-bending area, the cover plate includes a flexible part and a rigid part, the flexible part corresponds to the bending area, and the rigid part corresponds to the non-bending area.

In this application, the cover plate is in a soft-hard combination form, the flexible part may be bent, and the rigid part has good stiffness, and may be used for connection and fastening, thereby helping implement a narrow-bezel visual design and increase a screen-to-body ratio, to improve viewing experience of a user.

With reference to the second aspect, in some implementations of the second aspect, the rigid part is designed with a bending angle of less than 90°, and/or the flexible part is designed with a bending angle of greater than or equal to 180°.

With reference to the second aspect, in some implementations of the second aspect, a bending radius of the rigid part is greater than a bending radius of the flexible part.

With reference to the second aspect, in some implementations of the second aspect, a thickness of the flexible part is less than a thickness of the rigid part.

With reference to the second aspect, in some implementations of the second aspect, a material of the cover plate is any one of the following materials: glass and light-transmitting resin.

With reference to the second aspect, in some implementations of the second aspect, in a thickness direction of the flexible display, a groove is formed between the flexible part and the rigid part, a protrusion is disposed on the display layer, and the protrusion is embedded in the groove.

With reference to the second aspect, in some implementations of the second aspect, in the thickness direction of the flexible display, a groove is formed between the flexible part and the rigid part, and the groove is filled with a flexible material.

With reference to the second aspect, in some implementations of the second aspect, the flexible part includes a first material, the rigid part includes a second material, and the first material is different from the second material.

With reference to the second aspect, in some implementations of the second aspect, the first material is a flexible material; and/or the second material is a rigid material.

With reference to the second aspect, in some implementations of the second aspect, the first material includes at least one of the following materials: polypropylene, polyethylene, polyimide, polyamide, polyester resin, and thermoplastic polyurethane; and/or the second material includes at least one of the following materials: glass and light-transmitting resin.

With reference to the second aspect, in some implementations of the second aspect, a surface that is of the flexible part and that faces the rigid part in a first direction is connected to a surface that is of the rigid part and that faces the flexible part in the first direction. The first direction is perpendicular to a thickness direction of the flexible display and is perpendicular to a folding axis of the flexible display.

With reference to the second aspect, in some implementations of the second aspect, the flexible display further includes a connection layer, and the connection layer and the cover plate are stacked. The flexible part is connected to the connection layer, and the rigid part is connected to the connection layer.

With reference to the second aspect, in some implementations of the second aspect, a material of the connection layer is ultra-thin glass or optical resin.

With reference to the second aspect, in some implementations of the second aspect, the connection layer is disposed between the cover plate and the display layer; or the cover plate is disposed between the connection layer and the display layer.

With reference to the second aspect, in some implementations of the second aspect, the cover plate is disposed on a side that is of the display layer and on which a light-emitting surface is located.

### BRIEF DESCRIPTION OF DRAWINGS

FIG. 1 is a diagram of a structure of a foldable electronic device to which an embodiment of this application is applicable;
FIG. 2 is an exploded view of the foldable electronic device in FIG. 1;
FIGS. 3A and 3B are diagrams of two possible folded states of the foldable electronic device in FIG. 1;
FIG. 4 is a diagram of a structure of a flexible display according to an embodiment of this application;
FIG. 5 is a diagram of a fastening solution of a flexible display of an existing foldable electronic product;
FIG. 6 is a schematic cross-sectional view of a foldable electronic device according to an embodiment of this application;
FIGS. 7A and 7B are diagrams of a structure of a cover plate according to an embodiment of this application;
FIG. 8 is a diagram of a structure of a flexible display according to an embodiment of this application;
FIGS. 9A and 9B are diagrams of a structure of another flexible display according to an embodiment of this application;
FIGS. 10A-10C are diagrams of a structure of another flexible display according to an embodiment of this application;
FIG. 11 is a diagram of a structure of another flexible display according to an embodiment of this application; and
FIG. 12 is a diagram of a structure of another flexible display according to an embodiment of this application.

### DESCRIPTION OF EMBODIMENTS

The following describes the technical solutions of this application with reference to the accompanying drawings.

It should be noted that, in descriptions of embodiments of this application, unless otherwise specified, "/" means "or". For example, A/B may indicate A or B. In this specification, "and/or" merely describes an association relationship between associated objects, and indicates that three relationships may exist. For example, A and/or B may indicate the following three cases: Only A exists, both A and B exist, and only B exists.

The terms "first" and "second" in embodiments of this application are merely intended for a purpose of description, and shall not be understood as an indication or implication of relative importance or implicit indication of a quantity of indicated technical features. Therefore, a feature limited by "first", "second", or the like may explicitly or implicitly include one or more features. In addition, in the descriptions of embodiments of this application, "a plurality of" means two or more, and "at least one" and "one or more" mean one, two, or more. Singular expression forms "one", "a", "the", "the foregoing", "this", and "the one" are also intended to include expression forms such as "one or more", unless otherwise specified in the context clearly.

Reference to "one embodiment", "some embodiments", or the like described in this specification means that one or more embodiments of this application include a specific feature, structure, or characteristic described with reference to embodiments. Therefore, statements such as "in an embodiment", "in some embodiments", "in some other embodiments", and "in other embodiments" that appear at different places in this specification do not necessarily refer to a same embodiment, but mean "one or more but not all embodiments", unless otherwise specifically emphasized in another manner. The terms "include", "comprise", "have", and their variants all mean "include but are not limited to", unless otherwise specifically emphasized in another manner.

In the descriptions of embodiments of this application, orientations or location relationships indicated by terms such as "up", "down", "left", "right", "inner", "outer", "vertical", and "horizontal" are defined relative to orientations or locations of components schematically placed in the accompanying drawings. It should be understood that these orientation terms are relative concepts, and are used for relative description and clarification, instead of indicating or implying that specified apparatuses or components need to have specific orientations or are constructed and operated in specific orientations. The terms may vary correspondingly based on changes of the orientations of the components placed in the accompanying drawings, and therefore shall not be understood as a limitation on this application. In addition, "vertical" in this application is not strictly vertical, but within an allowable error range. "Parallel" is not strictly parallel, but within an allowable error range.

In embodiments of this application, same reference numerals indicate same components or parts. For same components or parts in embodiments of this application, only one component or part may be marked with a reference numeral in the figure as an example. It should be understood that, this is also applicable to reference numerals of other same components or parts. In addition, the parts in the accompanying drawings are not drawn to actual scale. Dimensions and sizes of the parts shown in the figures are merely examples, and should not be understood as a limitation on this application.

For ease of understanding, the following first explains and describes technical terms in this application.

Rigidity refers to a capability of a material or a structure to resist deformation. When an external force is fixed, a smaller deformation indicates greater rigidity of the material or the structure. When a deformation is fixed, a smaller external force indicates smaller rigidity of the material or the structure.

Flexibility refers to a capability of a material or a structure to accommodate deformation. When an external force is fixed, a greater deformation indicates greater flexibility of the material or the structure. When a deformation is fixed, a greater external force indicates smaller flexibility of the material or the structure.

Stiffness refers to a magnitude of an external force required to produce a unit deformation of an object, representing a capability of a material or structure to resist elastic deformation under a force.

Compliance refers to a displacement produced by an object under a unit load, representing a capability of a material or structure to be deformed under a force.

Compliance is a reciprocal of stiffness. Compliance and stiffness characterize a difficulty of elastic deformation of a material or structure.

Bending angle is an included angle formed by a material after bending.

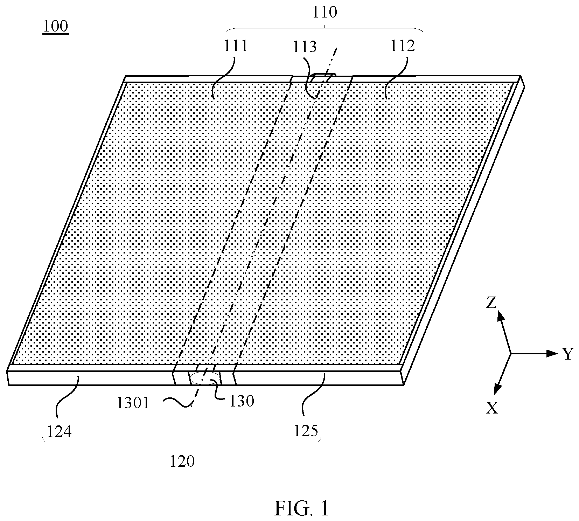

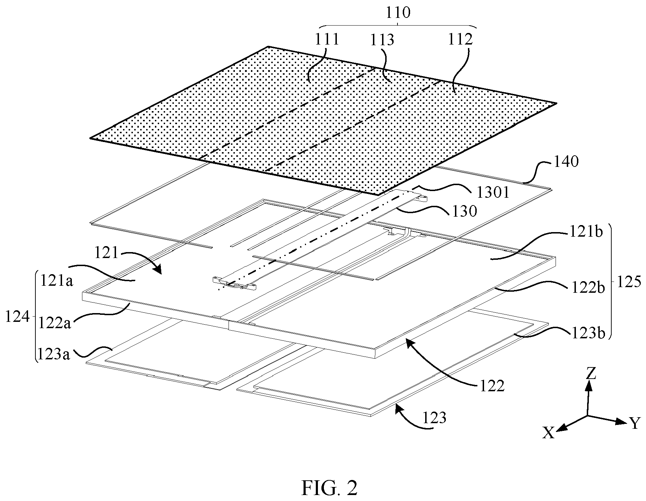

FIG. 1 and FIG. 2 are diagrams of a structure of a foldable electronic device 100 according to an embodiment of this application. FIG. 1 is a diagram of assembly of the foldable electronic device 100. FIG. 2 is an exploded view of the foldable electronic device 100.

In this embodiment of this application, the foldable electronic device 100 may be an electronic device with a folding function, such as a mobile phone, a tablet computer, a smartwatch, an e-reader, a notebook computer, or a wearable device. For ease of understanding, the embodiment shown in FIG. 1 and FIG. 2 is described by using a foldable mobile phone as an example.

For ease of description in the following, a direction parallel to a folding axis of the foldable electronic device 100 is defined as an X direction, a direction perpendicular to the folding axis of the foldable electronic device 100 is defined as a Y direction, a direction perpendicular to a screen when the foldable electronic device 100 is in an unfolded state is defined as a Z direction, and the Z direction is perpendicular to the X direction and is perpendicular to the Y direction. Herein, definitions of the X, Y, and Z directions are also applicable to the accompanying drawings to be described below. It should be noted that the definitions of the X, Y, and Z directions are merely intended to facilitate description of a location relationship and a connection relationship between components in embodiments of this application, and should not be construed as a limitation on embodiments of this application.

Refer to FIG. 1 and FIG. 2. The foldable electronic device 100 may include a flexible display 110 and a housing 120. The housing 120 forms accommodation space, and is configured to accommodate various components of the foldable electronic device 100. The flexible display 110 is disposed in the accommodation space formed by the housing 120, and is connected to the housing 120. The housing 120 may further protect the foldable electronic device 100 and support the entire foldable electronic device.

The flexible display 110 is configured to display an image. In FIG. 1 and FIG. 2, a structure filled with a dot matrix pattern is used as an example to indicate the flexible display 110. The flexible display 110 has features of strong flexibility and foldability, and can provide a user with a new foldability-based interaction mode. A display panel of the flexible display 110 may use any one of a liquid crystal display (liquid crystal display, LCD), an organic light-emitting diode (organic light-emitting diode, OLED), an active-matrix organic light-emitting diode (active-matrix organic light-emitting diode, AMOLED), a flexible light-emitting diode (flexible light-emitting diode, FLED), a quantum dot light-emitting diode (quantum dot light-emitting diode, QLED), and the like. This is not limited in embodiments of this application.

In this embodiment of this application, the flexible display 110 has a light-emitting surface that can display an image, and a surface that is of the flexible display 110 and that is disposed opposite to the light-emitting surface may be referred to as a back surface of the flexible display 110. The back surface of the flexible display 110 is accommodated in the accommodation space formed by the housing 120 and is invisible to the user.

Refer to FIG. 2. In some embodiments, the housing 120 of the foldable electronic device 100 may include a middle frame 121. The middle frame 121 is a support frame located inside the foldable electronic device 100. The middle frame 121 is usually made of a metal material, for example, copper, magnesium alloy, or stainless steel. In this embodiment of this application, the middle frame 121 may be configured to support and fasten the flexible display 110. For example, as shown in FIG. 2, the flexible display 110 (which may be specifically the back surface of the flexible display 110) may be bonded to the middle frame 121 by using an adhesive 140.

Refer to FIG. 2. In some embodiments, the housing 120 may further include a side frame 122. The side frame 122 is a structure surrounding a periphery of the foldable electronic device 100. For example, the side frame 122 may be disposed around a periphery of the flexible display 110, and may be configured to help fasten the flexible display 110. For example, the side frame 122 may be disposed around a periphery of the middle frame 121, and the side frame 122 is connected to the middle frame 121. The side frame 122 may be made of a metal material, for example, copper, magnesium alloy, or stainless steel, or may be made of a non-metal material, for example, plastic, glass, or ceramic.

Refer to FIG. 2. In some embodiments, the housing 120 may further include a back cover 123. The back cover 123 is usually disposed on the back of the foldable electronic device 100. For example, the back cover 123 is disposed on a side that is of the middle frame 121 and that is away from the flexible display 110. The back cover 123 is mainly configured to protect components, a battery, and the like inside the foldable electronic device 100. For example, the back cover 123 may prevent external impurities such as dust and water stains from entering the mobile phone. In some embodiments, the back cover 123 may be further configured to fasten a display other than the flexible display 110, or configured to fasten an antenna or the like.

In some embodiments, the middle frame 121, the side frame 122, and the back cover 123 may be three parts of the housing 120 of the foldable electronic device 100. In other words, the middle frame 121 may be connected to the side frame 122, and the side frame 122 may be connected to the back cover 123. A form of the connection includes but is not limited to clamping, bonding, welding, riveting, clearance fitting, and another detachable connection manner or non-detachable connection manner. In some other embodiments, the side frame 122 and the middle frame 121 may be of an integrated structure (or referred to as an integrated molding structure); or the side frame 122 and the back cover 123 may be of an integrated structure.

Refer to FIG. 2. In some embodiments, the middle frame 121 may include a first middle frame part 121a and a second middle frame part 121b that are arranged in a direction (a Y direction shown in FIG. 2) perpendicular to the folding axis of the foldable electronic device 100. The first middle frame part 121a and the second middle frame part 121b are respectively located on two sides of the folding axis of the foldable electronic device 100.

In some embodiments, the side frame 122 may include a first side frame part 122a and a second side frame part 122b that are arranged in the direction (the Y direction shown in FIG. 2) perpendicular to the folding axis of the foldable electronic device 100. The first side frame part 122a and the second side frame part 122b are respectively located on the two sides of the folding axis of the foldable electronic device 100.

In some embodiments, the back cover 123 may include a first back cover part 123a and a second back cover part 123b that are arranged in the direction (the Y direction shown in FIG. 2) perpendicular to the folding axis of the foldable electronic device 100. The first back cover part 123a and the second back cover part 123b are respectively located on the two sides of the folding axis of the foldable electronic device 100.

In embodiments of this application, at least a part of the first middle frame part 121a, the second middle frame part 121b, the first side frame part 122a, the second side frame part 122b, the first back cover part 123a, and the second back cover part 123b may form a first housing 124 and a second housing 125 that are configured to support the flexible display 110. Herein, the first housing 124 and the second housing 125 are two parts of the housing 120.

In other words, the housing 120 may include the first housing 124 and the second housing 125. The first housing 124 may include the first middle frame part 121a, and the second housing 125 may include the second middle frame part 121b. The first middle frame part 121a and the second middle frame part 121b are respectively located on the two sides of the folding axis of the foldable electronic device 100.

In some embodiments, the first housing 124 may further include the first side frame part 122a, and the second housing 125 may further include the second side frame part 122b. The first side frame part 122a and the second side frame part 122b are respectively located on the two sides of the folding axis of the foldable electronic device 100. The first side frame part 122a and the first middle frame part 121a are located on a same side of the folding axis of the foldable electronic device 100. The second side frame part 122b and the second middle frame part 121b are located on a same side of the folding axis of the foldable electronic device 100.

In some embodiments, the first housing 124 may further include the first back cover part 123a, and the second housing 125 may further include the second back cover part 123b. The first back cover part 123a and the second back cover part 123b are respectively located on the two sides of the folding axis of the foldable electronic device 100. The first back cover part 123a and the first middle frame part 121a are located on a same side of the folding axis of the foldable electronic device 100. The second back cover part 123b and the second middle frame part 121b are located on a same side of the folding axis of the foldable electronic device 100.

Refer to FIG. 1 and FIG. 2. In some embodiments, the foldable electronic device 100 may further include a connection mechanism 130, and the connection mechanism 130 includes a rotation axis 1301. The connection mechanism 130 is configured to connect two parts (the first housing 124 and the second housing 125 shown in FIG. 1 and FIG. 2) of the housing 120, so that a part of the housing 120 rotates around the rotation axis 1301 relative to the other part of the housing 120. For example, the first housing 124 and the second housing 125 rotate around the rotation axis 1301 relative to each other. Correspondingly, an electronic element disposed on the first housing 124 or an electronic element disposed on the second housing 125 may rotate around the rotation axis 1301, to implement folding and unfolding of the foldable electronic device 100.

Refer to FIG. 1 and FIG. 2. In some embodiments, the flexible display 110 may include a first display area 111 corresponding to the first housing 124, a second display area 112 corresponding to the second housing 125, and a third display area 113 corresponding to the connection mechanism 130. The third display area 113 is located between the first display area 111 and the second display area 112. Under the action of the connection mechanism 130, the first housing 124 and the second housing 125 may move close to or away from each other. Correspondingly, the third display area 113 is bent, and the first display area 111 and the second display area 112 may move close to or away from each other, so that the flexible display 110 may be folded or unfolded. In this embodiment of this application, during folding or unfolding of the flexible display 110 along the rotation axis 1301, the third display area 113 of the flexible display 110 is bent.

In an example, the connection mechanism 130 may include a main shaft, a first connection component, and a second connection component. The first connection component may be fastened to the first housing 124, and the second connection component may be fastened to the second housing 125. The first connection component and the second connection component may rotate relative to the main shaft. Mutual movement between the first connection component and the second connection component may drive mutual movement between the first housing 124 and the second housing 125, to implement folding and unfolding functions of the foldable electronic device 100.

The foldable electronic device 100 shown in FIG. 1 is in an unfolded state. In the unfolded state, an angle between the first housing 124 and the second housing 125 may be approximately 180°. The flexible display 110 may be in the unfolded state shown in FIG. 1, so that the user can conveniently use a large screen.

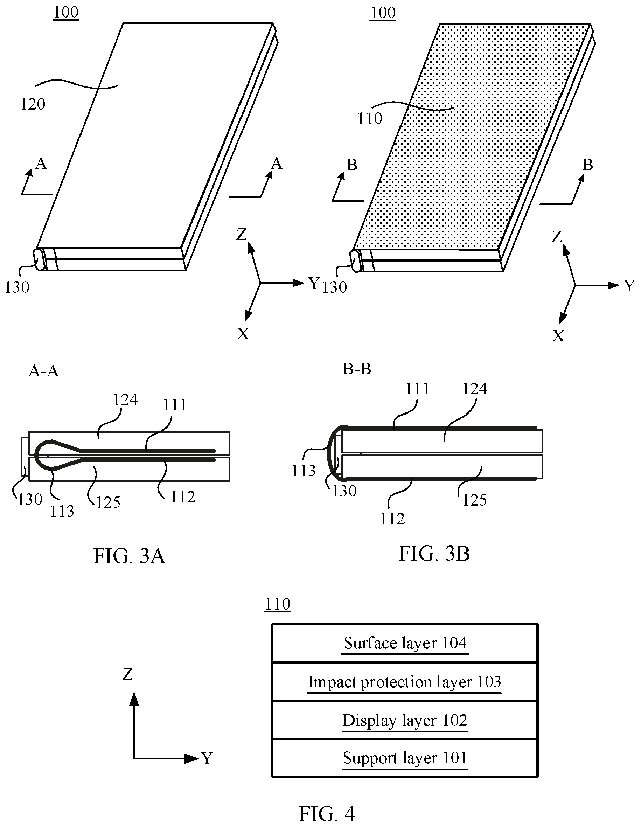

FIGS. 3A and 3B show two possible folded states of a foldable electronic device 100. In the folded state, the first housing 124 and the second housing 125 are parallel to each other, and the flexible display 110 is bent to a maximum bending degree of the flexible display 110.

FIG. 3A shows a state in which a screen of the foldable electronic device 100 is folded inward, namely, an inward folded state. In the inward folded state, refer to an A-A cross-section diagram shown in FIG. 3A. The first display area 111 and the second display area 112 face each other, the first housing 124 and the second housing 125 face away from each other, and the third display area 113 is bent. FIG. 3B shows a state in which the screen of the foldable electronic device 100 is folded outward, namely, an outward folded state. In the outward folded state, refer to a B-B cross-section diagram shown in FIG. 3B. The first display area 111 and the second display area 112 face away from each other, the first housing 124 and the second housing 125 face each other, and the third display area 113 is bent. It may be understood that when the foldable electronic device 100 is in the folded state, the foldable electronic device 100 is currently bent to a maximum bending degree of the foldable electronic device 100.

In this embodiment of this application, the foldable electronic device 100 can switch between the folded state and the unfolded state. When the foldable electronic device 100 is in the folded state, space occupied by the foldable electronic device 100 is small. When the foldable electronic device 100 is in the unfolded state, the foldable electronic device 100 may display a large screen, to increase a viewable range of the user.

It should be understood that FIG. 1 to FIGS. 3A and 3B merely schematically show some components included in the foldable electronic device 100. Shapes, sizes, and structures of these components are not limited by FIG. 1 to FIGS. 3A and 3B. In some other embodiments, the foldable electronic device 100 may further include more or fewer components than those shown in the figure. This is not limited in this embodiment of this application. In some other embodiments, a type of the foldable electronic device 100 is different and components included in the foldable electronic device 100 are different. A structure of the foldable electronic device provided in this embodiment of this application is merely an example for description.

It should be understood that FIG. 1 to FIGS. 3A and 3B merely schematically show that the foldable electronic device 100 includes two foldable parts (the first housing 124 and the second housing 125), in other words, the foldable electronic device 100 has one folding axis. In some other embodiments, the foldable electronic device 100 may further include three or more foldable parts. Correspondingly, the foldable electronic device 100 has two or more folding axes. In this way, the user may fold the foldable electronic device 100 for a plurality of times along a plurality of folding axes. As a quantity of foldable parts of the foldable electronic device 100 increases, when a screen size remains the same in the unfolded state, space occupied by the foldable electronic device 100 may be further reduced in the folded state, or when space occupied by the foldable electronic device 100 remains the same in the folded state, a displayed screen area may be further increased in the unfolded state.

The flexible display 110 is usually a multi-film layer stacking structure. FIG. 4 is a diagram of a structure of a flexible display 110. As shown in FIG. 4, the flexible display 110 may include a support layer 101, a display layer 102, an impact protection layer 103, and a surface layer 104 that are stacked.

The support layer 101 is located at a bottommost layer of the flexible display 110, and has specific hardness, to play a support role.

The display layer 102 is located between the support layer 101 and the impact protection layer 103, and includes a plurality of pixel units for displaying an image.

The impact protection layer 103 is located between the display layer 102 and the surface layer 104, and has specific degree of impact resistance and wear resistance, to resist external impact and protect the display layer 102. In some embodiments, the impact protection layer 103 may also be referred to as a cover plate.

The surface layer 104 is located on the impact protection layer 103, and has a scratch resistance function. The surface layer 104 may be easily separated from the impact protection layer 103 for replacement or removal when necessary.

It may be understood that the film layer stacking structure shown in FIG. 4 is merely an example. In some other embodiments, the flexible display 110 may further have another film layer stacking manner. For example, the flexible display 110 does not include the surface layer 104, or further includes another film layer. This is not limited in this embodiment of this application.

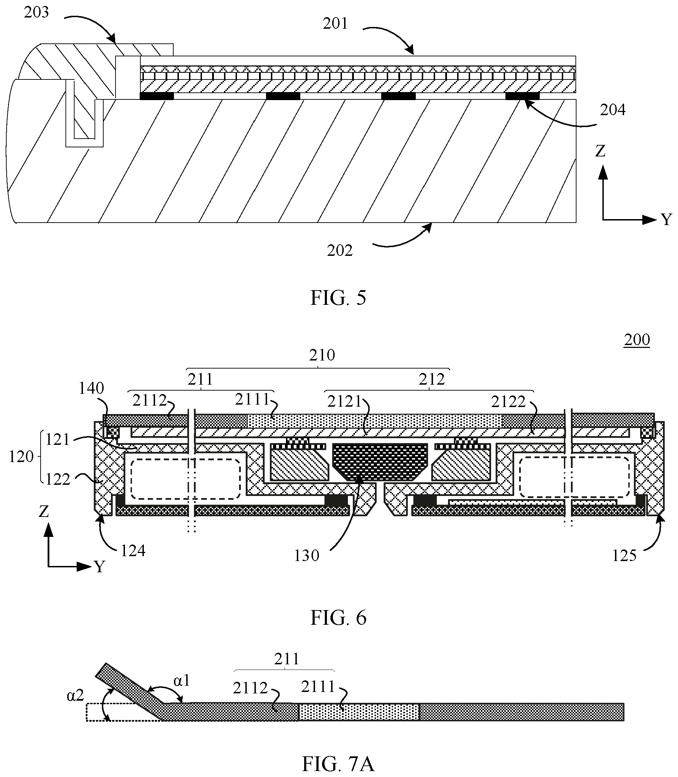

As described above, the flexible display 110 needs to be connected to the housing 120. FIG. 5 is a diagram of a current mainstream fastening solution of a flexible display of a foldable electronic product. As shown in FIG. 5, the foldable electronic product includes a flexible display 201 and a housing 202. To fasten the flexible display 201 to the housing 202, in the fastening solution of the flexible display shown in FIG. 5, an adhesive 204 is coated on a back surface of the flexible display 201 to bond and fasten the flexible display 201 to the housing 202, and a pressing cover 203 is further used to press a periphery of the flexible display 201 along a film layer stacking direction of the flexible display 201 to fasten a screen.

Herein, the pressing cover 203 may protect the screen and shield a screen edge appearance. Specifically, each film layer of the flexible display 201 is made of a soft flexible material, and has limited stretchability. During folding of the flexible display 201, a gap (that is, an edge gap) between a side surface of the flexible display 201 and a side surface of the housing 202 increases. An edge of the flexible display 201 may further warp, which enlarges the edge gap, so that dust, water stains, or the like may easily enter the edge gap. In addition, the edge warping may cause debonding and cracking of the flexible display 201. These problems may affect performance and a service life of the flexible display 201. The flexible display 201 is fastened by using the pressing cover 203, and the pressing cover 203 can cover the gap, thereby achieving protection effect. In addition, because the flexible display 201 is of the film layer stacking structure, during folding of the flexible display 201, misalignment may occur between film layers of the flexible display 201, and the pressing cover 203 may further shield an edge of the screen, thereby improving aesthetics.

However, to fasten the flexible display 201, the pressing cover 203 needs to partially overlap the flexible display 201. As a result, a size of the pressing cover 203 (for example, a size of the pressing cover 203 shown in FIG. 5 in a Y direction) is excessively wide, which causes large black borders visually and affects viewing experience of a user.

In view of this, this application provides a fastening solution of a flexible display, to avoid visual impact of large black borders caused by the pressing cover, and increase a screen-to-body ratio, thereby improving user experience.

FIG. 6 is a schematic cross-sectional view of a foldable electronic device according to an embodiment of this application. The foldable electronic device 200 shown in FIG. 6 is a specific example of the foldable electronic device 100 in FIG. 1 to FIGS. 3A and 3B.

As shown in FIG. 6, the foldable electronic device 200 includes a flexible display 210 and a housing 120. The flexible display 210 is accommodated in accommodation space formed by the housing 120, and the flexible display 210 is connected to the housing 120. The flexible display 210 may be folded or unfolded around a folding axis of the foldable electronic device 200. The flexible display 210 includes a cover plate 211 and a display layer 212 that are stacked. The display layer 212 includes a bending area 2121 and a non-bending area 2122, and the cover plate 211 includes a flexible part 2111 and a rigid part 2112. The flexible part 2111 of the cover plate 211 corresponds to the bending area 2121 of the display layer 212, the rigid part 2112 of the cover plate 211 corresponds to the non-bending area 2122 of the display layer 212, and the rigid part 2112 of the cover plate 211 is fastened to the housing 120.

For a description of the housing 120 in the foldable electronic device 200, refer to the foregoing description of the housing 120 in FIG. 1 to FIGS. 3A and 3B. For brevity, details are not described herein again. The flexible display 210 is a specific example of the flexible display 110 in FIG. 1 to FIGS. 3A and 3B. The following describes only a part that is not described above in detail. For other content of the flexible display 210, refer to the foregoing related descriptions of the flexible display 110 in FIG. 1 to FIGS. 3A and 3B.

It may be understood that, because the flexible display 210 is the film layer stacking structure, folding or unfolding the flexible display 210 is actually folding or unfolding each film layer of the flexible display 210. Therefore, each film layer of the flexible display 210 includes a bending area and a non-bending area. Bending areas of film layers correspond to each other, for example, a bending area of the cover plate 211 corresponds to the bending area of the display layer 212. Non-bending areas of the film layers correspond to each other, for example, a non-bending area of the cover plate 211 corresponds to the non-bending area of the display layer 212. Stacked bending areas of the film layers of the flexible display 210 may be considered as a bending area of the flexible display 210, and stacked non-bending areas of the film layers of the flexible display 210 may be considered as a non-bending area of the flexible display 210.

Based on this, in this embodiment of this application, the flexible part 2111 of the cover plate 211 corresponds to the bending area 2121 of the display layer 212. Therefore, it may be understood that the flexible part 2111 of the cover plate 211 corresponds to the bending area of the cover plate 211. The rigid part 2112 of the cover plate 211 corresponds to the non-bending area 2122 of the display layer 212. Therefore, it may be understood that the rigid part 2112 of the cover plate 211 corresponds to the non-bending area of the cover plate 211.

In this embodiment of this application, the display layer 212 is configured to display an image.

In this embodiment of this application, the cover plate 211 is configured to fasten the display layer 212 (actually, also fasten the flexible display 210). More specifically, the cover plate 211 includes the flexible part 2111 and the rigid part 2112. A position of the flexible part 2111 corresponds to a position of the bending area 2121 of the display layer 212. Because the flexible part 2111 has high compliance, during folding of the flexible display 210, the flexible part 2111 may be bent, and the cover plate 211 may be folded. A position of the rigid part 2112 corresponds to a position of the non-bending area 2122 of the display layer 212, and the rigid part 2112 does not need to be bent. In addition, because the rigid part 2112 has high stiffness, the rigid part 2112 may be fastened to the housing 120. Therefore, the cover plate 211 is fastened to the housing 120, and the flexible display 210 is connected to the housing 120.

In the fastening solution of the flexible display provided in this application, the cover plate 211 is not in a completely soft state, but in a soft-hard combination form. To be specific, the bending area of the cover plate 211 has high flexibility (and correspondingly low rigidity), and the non-bending area of the cover plate 211 has low flexibility (and correspondingly high rigidity). Therefore, the cover plate 211 may be connected to the housing 120 by using the non-bending area with high rigidity, and no additional pressing cover is needed for fastening. In this way, visual impact of large black borders caused by the pressing cover can be avoided, to implement a narrow-bezel visual design and increase a screen-to-body ratio, thereby improving viewing experience of the user.

Further, because the rigid part 2112 of the cover plate 211 is connected to the housing 120, during folding of the flexible display 210, there is no significant slippage between the cover plate 211 and the housing 120, and no obvious warping occurs at an edge of the cover plate 211, thereby reducing dust intrusion and protecting screen edges.

In addition, because the pressing cover is omitted, the solution provided in this application can further reduce assembly difficulty and processing costs of the foldable electronic device 200.

In this embodiment of this application, stiffness (or compliance) of the flexible part 2111 is different from stiffness (or compliance) of the rigid part 2112. Specifically, the compliance of the flexible part 2111 is greater than the compliance of the rigid part 2112. In other words, the stiffness of the rigid part 2112 is greater than the stiffness of the flexible part 2111.

In some embodiments, the flexible part 2111 of the cover plate 211 may be bent and can be obviously deformed, and the rigid part 2112 of the cover plate 211 cannot be bent, or can only be slightly deformed, or can be obviously deformed but a deformation generated under an acting force is far less than a deformation of the flexible part 2111 generated under a same acting force.

In some embodiments, a minimum bending angle of the rigid part 2112 is greater than 90°. For example, refer to FIG. 7A. After the rigid part 2112 is bent, a bending angle of the rigid part 2112 is an included angle α1 formed by parts that are of the rigid part 2112 and that are located on two sides of a bending line, where a minimum value of α1 is greater than 90°. When α1 is less than or equal to 90°, the rigid part 2112 breaks. In other words, for the cover plate 211, the rigid part 2112 of the cover plate 211 is not bent (that is, α1=180°), or the rigid part 2112 can be bent under an external force but the minimum bending angle is greater than 90°. That is, after the rigid part 2112 is bent, the parts located on the two sides of the bending line form an obtuse angle or a flat angle. Correspondingly, a maximum value of an included angle α2 between a part that is of the rigid part 2112 and that is on one side of the bending line and an extension line of the other part that is of the rigid part 2112 and that is on the other side of the bending line is less than 90°.

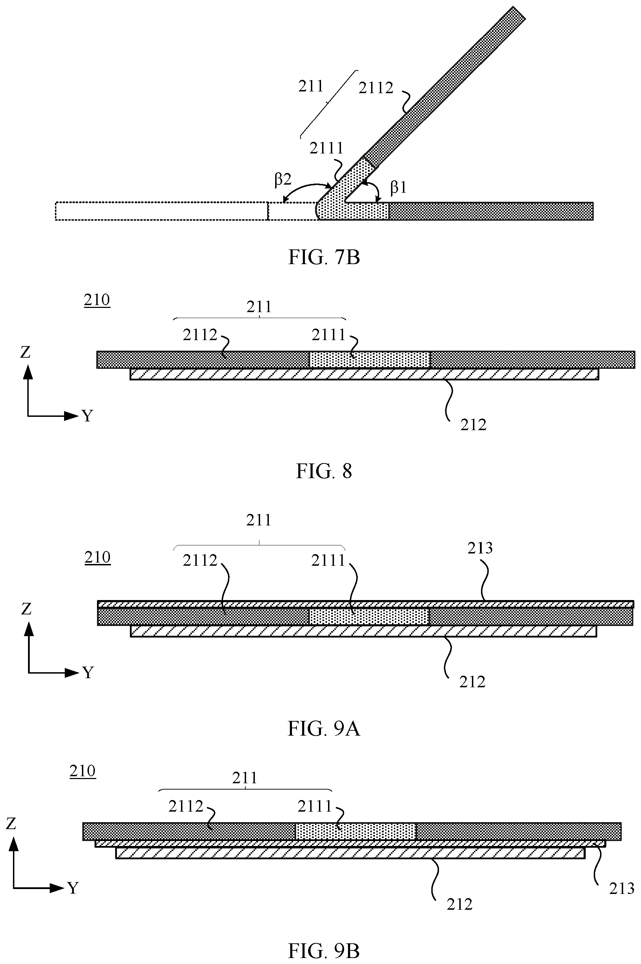

In some embodiments, a minimum bending angle of the flexible part 2111 is less than or equal to 0°. For example, refer to FIG. 7B. After the flexible part 2111 is bent, a bending angle of the flexible part 2111 is an included angle β1 formed by parts that are of the flexible part 2111 and that are located on two sides of a bending line, where a minimum value of β1 may be 0°. That is, after the flexible part 2111 is bent, the parts located on the two sides of the bending line may be parallel. In other words, for the cover plate 211, the flexible part 2111 can be bent under an external force, and the minimum bending angle of the flexible part 2111 may be 0°. Correspondingly, a maximum value of an included angle β2 between a part that is of the flexible part 2111 and that is on one side of the bending line and an extension line of the other part that is of the flexible part 2111 and that is on the other side of the bending line may be 180°. The minimum bending angle of the flexible part 2111 herein is less than 0°, which may be understood as that the flexible part 2111 can be rolled.

In some embodiments, a bending radius of the rigid part 2112 is greater than a bending radius of the flexible part 2111. Alternatively, for the cover plate 211, a bending radius of the rigid part 2112 when the rigid part 2112 is bent under an external force is greater than a bending radius of the flexible part 2111 when the flexible part 2111 is bent under a same external force.

In this way, the rigid part 2112 of the cover plate 211 has high rigidity, and is not prone to reverse bending or arching, which facilitates a fastened connection with the housing 120. The flexible part 2111 of the cover plate 211 has high flexibility, and does not affect folding and unfolding of the flexible display 210.

In this embodiment of this application, a fastened connection manner between the rigid part 2112 of the cover plate 211 and the housing 120 may be a detachable connection or a non-detachable connection. A specific connection manner includes but is not limited to bonding, clamping, welding, or the like.

In some embodiments, the rigid part 2112 of the cover plate 211 is bonded and fastened to the housing 120. For example, as shown in FIG. 6, the rigid part 2112 may be bonded to the housing 120 by using the adhesive 140. The adhesive 140 is used to bond the cover plate 211 and the housing 120, which is simple, fast, and efficient. In addition, the adhesive 140 may be used to bond same materials or different materials, and is not limited by a shape and a thickness of the material, and has stable performance.

In some embodiments, the housing 120 includes a middle frame 121, and the rigid part 2112 of the cover plate 211 may be connected to the middle frame 121.

In some embodiments, the housing 120 includes a side frame 122, and the rigid part 2112 of the cover plate 211 may be connected to the side frame 122.

For descriptions of the middle frame 121 and the side frame 122, refer to the foregoing related content in FIG. 1 to FIGS. 3A and 3B. For brevity, details are not described herein again.

In some embodiments, the housing 120 may include a first housing 124 and a second housing 125. The foldable electronic device 200 further includes a connection mechanism 130, and parts of the connection mechanism 130 that are located on two sides of the folding axis are respectively connected to the first housing 124 and the second housing 125. That is, the first housing 124 is connected to the second housing 125 by using the connection mechanism 130. The first housing 124 and the second housing 125 may rotate around the connection mechanism 130 relative to each other, to implement unfolding and folding of the foldable electronic device 200. The position of the flexible part 2111 of the cover plate 211 corresponds to a position of the connection mechanism 130, and the rigid part 2112 of the cover plate 211 is connected to the first housing 124 and the second housing 125.

That the position of the flexible part 2111 corresponds to the position of the connection mechanism 130 does not affect folding and unfolding of the flexible display 210.

In some embodiments, a back surface of the flexible display 210 is connected to the housing 120 by using the adhesive 140. In this embodiment of this application, because the rigid part 2112 of the cover plate 211 has good stiffness, a partial tensile force concentration on the screen caused by adhesive dispensing on the back surface of the flexible display 210 (especially the non-bending area of the flexible display 210) can be reduced, thereby mitigating a light-and-shadow sudden change caused by the partial tensile force concentration on the screen (that is, light-and-shadow uneven effect).

Certainly, in some other embodiments, the back surface of the flexible display 210 may alternatively be fastened to the housing 120, without adhesive bonding, to avoid partial tensile force concentration on the screen caused by adhesive dispensing, thereby avoiding the light-and-shadow sudden change caused by the partial tensile force concentration on the screen.

In this embodiment of this application, there are a plurality of manners for implementing the cover plate 211 to be in the soft-hard combination form. The following provides detailed descriptions with reference to FIG. 8 to FIG. 12.

FIG. 8 is a diagram of a structure of a flexible display according to an embodiment of this application.

As shown in FIG. 8, the flexible display 210 includes a cover plate 211 and a display layer 212 that are stacked. The cover plate 211 is disposed on the display layer 212, that is, the cover plate 211 is disposed on a side that is of the display layer 212 and on which a light-emitting surface is located. The cover plate 211 includes a flexible part 2111 and a rigid part 2112, where the flexible part 2111 includes a first material, the rigid part 2112 includes a second material, and the first material is different from the second material. In other words, the cover plate 211 may be formed by joining a plurality of materials, which helps ensure both a bendable function of the flexible part 2111 and good stiffness of the rigid part 2112.

In this embodiment of this application, stiffness (or compliance) of the first material is different from stiffness (or compliance) of the second material. For example, the compliance of the first material is greater than the compliance of the second material, or the stiffness of the second material is greater than the stiffness of the first material.

In some embodiments, the first material is a flexible material.

In some embodiments, the first material may include an organic film material. For example, the first material includes at least one of the following materials: polypropylene (polypropylene, PP), polyethylene (polyethylene, PE), polyimide (polyimide, PI), polyamide (polyamide, PA), polyethylene terephthalate (polyethylene terephthalate, PET) (also referred to as polyester resin), thermoplastic polyurethane (thermoplastic polyurethane, TPU), and the like.

In this way, the flexible part 2111 of the cover plate 211 has high flexibility, and does not affect folding and unfolding of the flexible display 210.

In some embodiments, the second material is a rigid material.

In some embodiments, the second material includes at least one of the following materials: glass, transparent resin (or referred to as light-transmitting resin), and the like. For example, the glass may include plexiglass and plexiglass (that is, polymethyl methacrylate).

In this way, the rigid part 2112 of the cover plate 211 has high rigidity, which facilitates fastened connection to the housing 120.

There are a plurality of joining manners between the flexible part 2111 and the rigid part 2112. The following provides descriptions with reference to FIG. 8 and FIGS. 9A and 9B.

In an example, as shown in FIG. 8, the flexible part 2111 is connected to the rigid part 2112 through respective surfaces in a first direction. Herein, the first direction is perpendicular to a thickness direction of the flexible display 210 (that is, a film layer stacking direction of the flexible display 210, for example, a Z direction shown in FIG. 8) and is perpendicular to the folding axis of the flexible display 210, for example, refer to a Y direction in FIG. 8. More specifically, a surface that is of the flexible part 2111 and that faces the rigid part 2112 in the first direction (for example, the Y direction shown in the figure) is connected to a surface that is of the rigid part 2112 and that faces the flexible part 2111 in the first direction.

In this way, no additional film layer is needed, which helps reduce a stacking thickness of the flexible display 210.

For example, a joining manner between the flexible part 2111 and the rigid part 2112 (that is, a joining manner between the first material and the second material) includes but is not limited to injection molding, welding, hot melting, and the like.

In another example, as shown in FIGS. 9A and 9B, the flexible display 210 further includes a connection layer 213. The connection layer 213 and the cover plate 211 are stacked. The flexible part 2111 is connected to the connection layer 213, and the rigid part 2112 is connected to the connection layer 213. In this way, the flexible part 2111 and the rigid part 2112 may be joined together by using the connection layer 213. More specifically, a projection of the connection layer 213 in the thickness direction of the flexible display 210 overlaps a projection of the flexible part 2111 in the thickness direction of the flexible display 210. The projection of the connection layer 213 in the thickness direction of the flexible display 210 overlaps a projection of the rigid part 2112 in the thickness direction of the flexible display 210. A surface that is of the flexible part 2111 and that faces the connection layer 213 in the thickness direction is connected to a surface that is of the connection layer 213 and that faces the flexible part 2111 in the thickness direction. A surface that is of the rigid part 2112 and that faces the connection layer 213 in the thickness direction is connected to a surface that is of the connection layer 213 and that faces the rigid part 2112 in the thickness direction.

In this way, the rigid part 2112 is connected to the flexible part 2111 by using the connection layer 213, so that a contact area can be increased, and connection reliability can be ensured.

For example, a connection manner between the cover plate 211 and the connection layer 213 may be bonding. For example, the cover plate 211 and the connection layer 213 are bonded together by using an optically clear adhesive (optically clear adhesive, OCA).

In some embodiments, a material of the connection layer 213 is a flexible material, for example, ultra-thin glass or optical resin. In this way, the connection layer 213 may be folded and unfolded, without affecting bendable performance of the flexible display 210.

In some embodiments, in the thickness direction of the flexible display 210, the connection layer 213 may be disposed on the cover plate 211. For example, as shown in FIG. 9A, the cover plate 211 is disposed between the connection layer 213 and the display layer 212.

Similar to the structure shown in FIG. 4, in some embodiments, based on a structure shown in FIG. 9A, the flexible display 210 may further include the support layer 101 and the surface layer 104 shown in FIG. 4. The support layer 101 is located below the display layer 212, that is, the display layer 212 is located between the support layer 101 and the cover plate 211. The surface layer 104 is located on the connection layer 213, that is, the connection layer 213 is located between the surface layer 104 and the cover plate 211.

In some other embodiments, in the thickness direction of the flexible display 210, the connection layer 213 may be disposed below the cover plate 211. For example, as shown in FIG. 9B, the connection layer 213 is disposed between the display layer 212 and the cover plate 211. For example, an edge of the connection layer 213 may be recessed toward a center of the screen relative to an edge of the rigid part 2112. In this way, the connection layer 213 does not affect the connection between the rigid part 2112 and the housing 120.

Similar to the structure shown in FIG. 4, in some embodiments, based on a structure shown in FIG. 9B, the flexible display 210 may further include the support layer 101 and the surface layer 104 shown in FIG. 4. The support layer 101 is located below the display layer 212, that is, the display layer 212 is located between the support layer 101 and the connection layer 213. The surface layer 104 is located on the cover plate 211, that is, the cover plate 211 is located between the surface layer 104 and the connection layer 213.

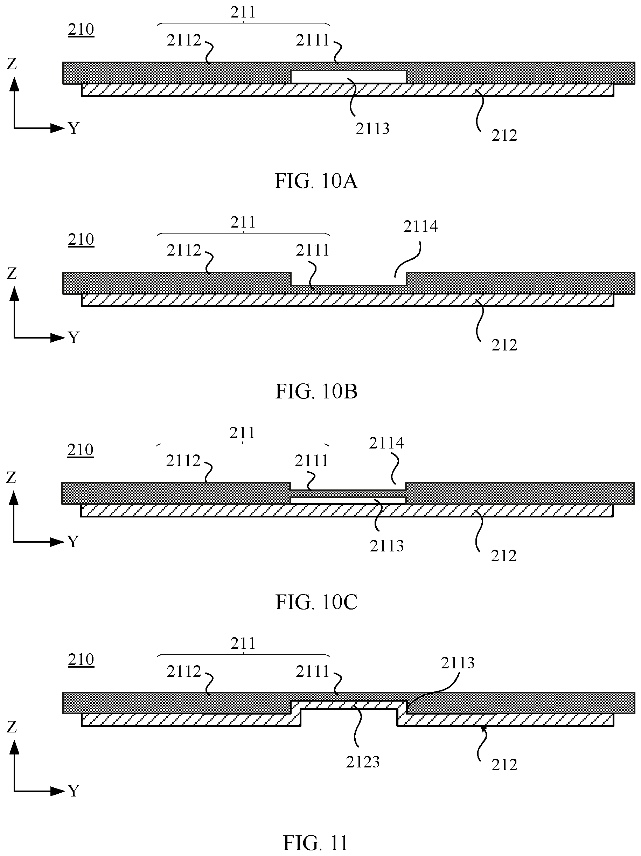

FIGS. 10A-10C are diagrams of a structure of another flexible display according to an embodiment of this application.

As shown in FIGS. 10A-10C, the flexible display 210 includes a cover plate 211 and a display layer 212 that are stacked, and the cover plate 211 is disposed on the display layer 212. The cover plate 211 includes a flexible part 2111 and a rigid part 2112, where a thickness of the flexible part 2111 is less than a thickness of the rigid part 2112. It may be understood that the thickness herein refers to a size of the flexible display 210 in a film layer stacking direction (refer to a Z direction in FIGS. 10A-10C).

In this embodiment, the flexible part 2111 and the rigid part 2112 are formed by partially thinning a thickness of the cover plate 211. The flexible part 2111 has a relatively small thickness, and can implement a bending function.

In some embodiments, a material of the flexible part 2111 may be the same as a material of the rigid part 2112. For example, the entire cover plate 211 is obtained by processing a same material. As an example instead of a limitation, a material of the cover plate 211 may be glass, light-transmitting resin, or the like.

In some other embodiments, the material of the flexible part 2111 may be different from the material of the rigid part 2112. For example, the flexible part 2111 includes a first material, the rigid part 2112 includes a second material, and the first material is different from the second material. As an example instead of a limitation, the first material includes at least one of the following materials: polypropylene PP, polyethylene PE, polyimide PI, polyamide PA, polyester resin PET, thermoplastic polyurethane TPU, glass, and transparent resin. The second material may include at least one of the following materials: glass and transparent resin.

In this embodiment, the first material and the second material may be joined together. For a joining manner, refer to the methods described in FIG. 8 to FIGS. 9A and 9B. For details, refer to the foregoing related descriptions. For brevity, details are not described herein again.

In this embodiment of this application, there are a plurality of manners of performing partial thinning treatment on the cover plate 211.

In an example, the cover plate 211 may be first integrally formed with a uniform thickness, and then a material removal process is performed on some areas to form the flexible part 2111.

In another example, the cover plate 211 may be directly integrally formed with a non-equal thickness, and an area with a small thickness is the flexible part 2111.

In still another example, the rigid part 2112 and the flexible part 2111 of the cover plate 211 may be separately fabricated and then joined together.

In this embodiment of this application, as shown in FIGS. 10A-10C, the cover plate 211 is provided with a groove, for example, a first groove 2113 shown in FIGS. 10A and 10B or a second groove 2114 shown in FIGS. 10B and 10C, where a part that is of the cover plate and that corresponds to the groove is the flexible part 2111. In other words, in the thickness direction of the flexible display 210, a groove is formed between the rigid part 2112 and the flexible part 2111, where a bottom wall of the groove belongs to the flexible part 2111, and a side wall of the groove belongs to the rigid part 2112.

In this embodiment of this application, there are a plurality of manners of providing a groove in the cover plate 211. The following provides detailed descriptions with reference to FIGS. 10A-10C.

In an example, refer to FIG. 10A. A groove provided in the cover plate 211 include the first groove 2113, the first groove 2113 is close to the display layer 212, and the rigid part 2112 of the cover plate 211 is connected to the display layer 212. In this example, it may also be considered that the first groove 2113 is opened on a side that is of the cover plate 211 and that faces a back surface of the flexible display 210.

In another example, refer to FIG. 10B. A groove provided in the cover plate 211 include the second groove 2114, the second groove 2114 is far away from the display layer 212, and both the flexible part 2111 and the rigid part 2112 of the cover plate 211 are connected to the display layer 212. In this example, it may also be considered that the second groove 2114 is opened on a side that is of the cover plate 211 and that faces a light-emitting surface of the flexible display 210.

In still another example, refer to FIG. 10C. A groove provided in the cover plate 211 include the first groove 2113 and the second groove 2114. The first groove 2113 is close to the display layer 212, the second groove 2114 is far away from the display layer 212, and the rigid part 2112 of the cover plate 211 is connected to the display layer 212.

In the example of FIG. 10A, the first groove 2113 is close to the display layer 212. In some embodiments, as shown in FIG. 10A, a surface that is of the rigid part 2112 of the cover plate 211 and that faces the display layer 212 is adhered (or attached) to the display layer 212, and a surface that is of the flexible part 2111 and that faces the display layer 212 is not adhered (or attached) to the display layer 212. In other words, space formed by the first groove 2113 and the display layer 212 is filled with air.

In some other embodiments, as shown in FIG. 11, the cover plate 211 includes a first groove 2113, and the first groove 2113 is close to the display layer 212. A surface that is of the rigid part 2112 of the cover plate 211 and that faces the display layer 212 is attached to the display layer 212, and an inner wall (including a side wall and/or a bottom wall) of the first groove 2113 is attached to the display layer 212. In other words, a surface that is of the cover plate 211 and that faces the display layer 212 is attached to a surface that is of the display layer 212 and that faces the cover plate 211. A protrusion 2123 is disposed on the display layer 212, and the protrusion 2123 is embedded in the first groove 2113. It may be understood that the solution shown in FIG. 11 is also applicable to the case shown in FIG. 10C, and details are not described herein again. In this way, display effect can be improved.

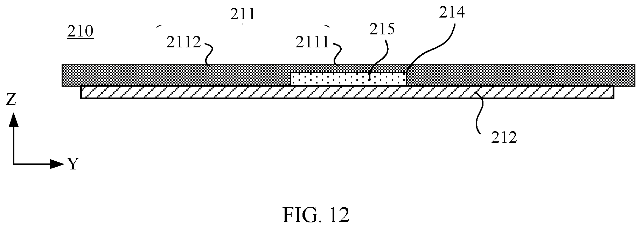

In some other embodiments, as shown in FIG. 12, a groove 214 is provided in the cover plate 211, and a flexible material 215 is disposed in the groove 214. In this way, smoothness of display effect can be ensured.

For example, the groove 214 includes the first groove 2113 shown in FIG. 10A or FIG. 10C. The flexible material 215 is disposed in the first groove 2113. A surface that is of the rigid part 2112 and that faces the display layer 212 is attached to the display layer 212, and a surface that is of the flexible material 215 and that faces the display layer 212 is attached to the display layer 212. For another example, the groove 214 includes the second groove 2114 shown in FIG. 10B or FIG. 10C, and the second groove 2114 is filled with the flexible material 215.

As an example instead of a limitation, the flexible material 215 may include at least one of the following materials: optically clear adhesive (optically clear adhesive, OCA), polypropylene PP, polyethylene PE, polyimide PI, polyamide PA, polyester resin PET, thermoplastic polyurethane TPU, and the like.

It may be understood that a length direction of a groove (for example, the groove 214, the first groove 2113, and the second groove 2114) in embodiments of this application is parallel to the folding axis of the flexible display 210, and a width direction of the groove is perpendicular to the folding axis of the flexible display 210 and is perpendicular to the thickness direction of the flexible display 210.

In some embodiments, a width of the groove 214 may approximately correspond to a width of the connection mechanism 130.

In this embodiment of this application, a position of the cover plate 211 is not limited to the position shown in FIG. 8 to FIG. 12 in which the cover plate 211 is located on the display layer 212. In some other embodiments, the cover plate 211 may alternatively be located below the display layer 212. The joining manner, the thinning treatment manner, the groove arrangement manner, the flexible filling material arrangement, and the like in the foregoing embodiments are also applicable. For details, refer to the foregoing related descriptions. For brevity, details are not described herein again.

In this embodiment of this application, the cover plate 211 may be directly attached to the display layer 212, or another film layer may be disposed between the cover plate 211 and the display layer 212. The joining manner, the thinning treatment manner, the groove arrangement manner, the flexible filling material arrangement, and the like in the foregoing embodiments are also applicable. For details, refer to the foregoing related descriptions. For brevity, details are not described herein again.

According to the manner provided in this embodiment of this application, a narrow-bezel visual design can be implemented and a screen-to-body ratio can be increased, thereby improving viewing experience of the user.

In the descriptions of this application, it should be noted that the terms "mount", "interconnect", and "connection" should be understood in a broad sense unless there is a clear stipulation and limitation. For example, such terms may indicate a fastened connection, a detachable connection, or an integral connection; may indicate a mechanical connection or an electrical connection; and may indicate a direct connection, an indirect connection through an intermediate medium, or internal communication between two elements. A person of ordinary skill in the art may understand specific meanings of the foregoing terms in this application based on a specific situation.

The foregoing descriptions are merely specific implementations of this application, but are not intended to limit the protection scope of this application. Any variation or replacement readily figured out by a person skilled in the art within the technical scope disclosed in this application shall fall within the protection scope of this application. Therefore, the protection scope of this application shall be subject to the protection scope of the claims.

## Claims

1. A foldable electronic device, comprising:
a housing; and
a flexible display, wherein the flexible display comprises a cover plate and a display layer that are stacked, the display layer comprises a bending area and a non-bending area, the cover plate comprises a flexible part and a rigid part, the flexible part corresponds to the bending area, the rigid part corresponds to the non-bending area, and the rigid part is fastened to the housing.

2. The foldable electronic device according to claim 1, wherein the rigid part is bonded and fastened to the housing.

3. The foldable electronic device according to claim 1 or 2, wherein
the housing comprises a middle frame, and the rigid part is fastened to the middle frame; and/or
the housing comprises a side frame, and the rigid part is fastened to the side frame.

4. The foldable electronic device according to any one of claims 1 to 3, wherein the foldable electronic device further comprises a connection mechanism, the housing comprises a first housing and a second housing, the first housing and the second housing are rotatably connected to the connection mechanism separately, a position of the flexible part corresponds to a position of the connection mechanism, and the rigid part is connected to the first housing and the second housing.

5. The foldable electronic device according to any one of claims 1 to 4, wherein
a back surface of the flexible display is bonded to the housing; or
a back surface of the flexible display is not bonded to the housing.

6. The foldable electronic device according to any one of claims 1 to 5, wherein a thickness of the flexible part is less than a thickness of the rigid part.

7. The foldable electronic device according to claim 6, wherein a material of the cover plate is any one of the following materials: glass and light-transmitting resin.

8. The foldable electronic device according to claim 6 or 7, wherein
in a thickness direction of the flexible display, a groove is formed between the flexible part and the rigid part, a protrusion is disposed on the display layer, and the protrusion is embedded in the groove; or
in a thickness direction of the flexible display, a groove is formed between the flexible part and the rigid part, and the groove is filled with a flexible material.

9. The foldable electronic device according to any one of claims 1 to 6, wherein the flexible part comprises a first material, the rigid part comprises a second material, and the first material is different from the second material.

10. The foldable electronic device according to claim 9, wherein
the first material comprises at least one of the following materials: polypropylene, polyethylene, polyimide, polyamide, polyester resin, and thermoplastic polyurethane; and/or
the second material comprises at least one of the following materials: glass and light-transmitting resin.

11. The foldable electronic device according to claim 9 or 10, wherein a surface that is of the flexible part and that faces the rigid part in a first direction is connected to a surface that is of the rigid part and that faces the flexible part in the first direction, and the first direction is perpendicular to a thickness direction of the flexible display and is perpendicular to a folding axis of the flexible display.

12. The foldable electronic device according to any one of claims 9 to 11, wherein the flexible display further comprises a connection layer, the connection layer and the cover plate are stacked, the flexible part is connected to the connection layer, and the rigid part is connected to the connection layer.

13. The foldable electronic device according to claim 12, wherein a material of the connection layer is ultra-thin glass or optical resin.

14. The foldable electronic device according to claim 12 or 13, wherein
the connection layer is disposed between the cover plate and the display layer; or
the cover plate is disposed between the connection layer and the display layer.

15. The foldable electronic device according to any one of claims 1 to 14, wherein the cover plate is disposed on a side that is of the display layer and on which a light-emitting surface is located.

16. A flexible display, comprising a cover plate and a display layer that are stacked, wherein the display layer comprises a bending area and a non-bending area, the cover plate comprises a flexible part and a rigid part, the flexible part corresponds to the bending area, and the rigid part corresponds to the non-bending area.

17. The flexible display according to claim 16, wherein a thickness of the flexible part is less than a thickness of the rigid part.

18. The flexible display according to claim 17, wherein a material of the cover plate is any one of the following materials: glass and light-transmitting resin.

19. The flexible display according to claim 17 or 18, wherein
in a thickness direction of the flexible display, a groove is formed between the flexible part and the rigid part, a protrusion is disposed on the display layer, and the protrusion is embedded in the groove; or
in a thickness direction of the flexible display, a groove is formed between the flexible part and the rigid part, and the groove is filled with a flexible material.

20. The flexible display according to any one of claims 16 to 19, wherein the flexible part comprises a first material, the rigid part comprises a second material, and the first material is different from the second material.

21. The flexible display according to claim 20, wherein
the first material comprises at least one of the following materials: polypropylene, polyethylene, polyimide, polyamide, polyester resin, and thermoplastic polyurethane; and/or
the second material comprises at least one of the following materials: glass and light-transmitting resin.

22. The flexible display according to claim 20 or 21, wherein a surface that is of the flexible part and that faces the rigid part in a first direction is connected to a surface that is of the rigid part and that faces the flexible part in the first direction, and the first direction is perpendicular to a thickness direction of the flexible display and is perpendicular to a folding axis of the flexible display.

23. The flexible display according to any one of claims 20 to 22, wherein the flexible display further comprises a connection layer, the connection layer and the cover plate are stacked, the flexible part is connected to the connection layer, and the rigid part is connected to the connection layer.

24. The flexible display according to claim 23, wherein a material of the connection layer is ultra-thin glass or optical resin.

25. The flexible display according to claim 23 or 24, wherein
the connection layer is disposed between the cover plate and the display layer; or
the cover plate is disposed between the connection layer and the display layer.

26. The flexible display according to any one of claims 16 to 25, wherein the cover plate is disposed on a side that is of the display layer and on which a light-emitting surface is located.
